# EUROPEAN PATENT APPLICATION

(11) **EP 4 703 792 A1**
(43) Date of publication of application: **04.03.2026**
(21) Application number: 24196855.1
(22) Date of filing: 28.08.2024
(51) Int. Cl.: G03F 7/00

(54) **LASER WRITING WITH A NON-CONSTANT EXPOSURE VELOCITY**

(71) Applicant: MYCRONIC AB, 183 03 Täby (SE)
(72) Inventor: Glimtoft, Martin, 125 58 Älvsjö (SE); Walther, Jonas, 169 37 Solna (SE)
(74) Representative: AWA Sweden AB

(57) **Abstract**

There is disclosed herein a method for controlling a laser writer (100) and a laser writer (100) configured to perform such a method. The laser writer (100) comprises a printing head (102), a modulating optic (108), and a sweep deflection optic (110). The printing head (102) scans in a scanning direction (*X*) relative to a printing substrate (104), with a predetermined non-constant velocity profile. The sweep deflection optic (110) is controlled to carry out a micro-sweep based on a monitored position of the printing head (102) along the scan direction (*X*).

## Description

### Technical Field

The present disclosure relates to laser writing for creating micro- or nano-scale surface patterns, which may be used in microlithography systems or the like. More particularly, the present disclosure relates to a method for controlling a laser writer, and a laser writer that carries out such a method.

### Background

In the area of pattern generation, such as in mask printing, optical elements may be used for causing splitting, changes in intensity, and/or deflection of one or more laser beams when printing a pattern onto a printing substrate such as a photo-sensitive resist. Such optical elements may include a modulating optic such as an acousto-optical modulator (AOM) and a deflecting optic such as an acousto-optical deflector (AOD), which may modify one or more laser beams which are directed to a printing head that is scanned across the printing substrate to thereby generate the pattern.

The modulating optic may modulate the intensity of each of the one or more laser beams according to the desired pattern, and the sweep deflection optic may sweep the one or more laser beams across the printing substrate in a direction that is substantially perpendicular the scanning direction.

Hence, a laser writer can generate a pattern by moving the printing head relative to the printing substrate, in a scan direction, with the pattern encoded into a laser beam by the modulating optic, while carrying a number of micro-sweeps perpendicular to the scanning direction using the sweep deflection optic. In this way, a printing efficiency is enhanced, as the micro-sweeps can be carried out on a timescale faster than the relative motion of the printing head in the scan direction, and thus a wider strip of the printing substrate can be written on for each scan of the printing head thereacross.

However, as the demand for printed substrates increases, it may be desired to increase the speed with which they can be printed, without impacting the accuracy of the pattern printed thereon.

### Summary

Conventional laser writers only write onto the printing substrate during constant motion of the printing head in the scan direction. However, it is realized as a part of the present disclosure that the printing efficiency can be further enhanced by also writing during acceleration and/or deceleration of the printing head (i.e., at the start and end of each scan). Aspects of the present disclosure are thus directed at enabling such writing during a non-constant motion of the printing head, which implementation has numerous associated difficulties, especially when it is important to maintain precision in writing nano-scale patterns.

Thus, according to an aspect of the present disclosure, there is provided a method of controlling a laser writer, comprising moving a printing head in a scan direction relative to a printing substrate, directing one or more laser beams through a modulating optic, and directing the one or more laser beams from the modulating optic to a sweep deflection optic, wherein the sweep deflection optic is controlled according to a sweep pattern to vary a deflection angle of the one or more laser beams over time to thereby achieve a micro-sweep of the laser beam across the printing substrate in a sweep direction substantially perpendicular to the scan direction.

The modulating optic is controlled according to a data pattern to modulate the intensity of each of the one or more laser beams, and the data pattern corresponds to a printing pattern to be printed onto the printing substrate. The printing pattern may comprise a nano-scale pattern for printing onto the printing substrate, where the printing substrate may comprise one or more materials that are affected/developed (e.g., shaped, colored, chemically altered such as polymer degradation, etc.) by the one or more laser beams. For example, the printing substrate may comprise a base substrate with a photoresist layer, and the printing substrate, having the pattern printed thereupon, may be used to form a photomask for use in the manufacture of electronic displays, for example.

The data pattern may comprise information for each of the one or more laser beams, and how they should vary in time during printing to generate the printed pattern on the printing substrate. The data pattern may vary between a lowest value and a highest value, which may correspond to a minimum and maximum intensity of the one or more laser beams, at least as used in the particular pattern being printed. The particulars of how the pattern to be printed is transformed into the data pattern are less relevant for understanding the present disclosure and are therefore not discussed in detail herein.

The relative motion between the printing head and the printing substrate may comprise an acceleration from a relative stationary position, e.g., at the initiation of the printing or the initiation of a particular scan of the printing head in the scan direction, and a deceleration to return to the relative stationary position. For this reason, and/or other reasons, the relative movement of the printing head and the printing substrate is non-constant, at least during these acceleration and deceleration stages.

It is realized as a part of the present disclosure that the non-constant relative motion of the printing head and the printing substrate can be predetermined and, in such cases, the effects of the non-constant relative motion to the printing output can be accommodated for, and hence printing can be carried out even during non-constant relative motion of the printing head and the printing substrate, thereby substantially increasing the printing efficiency of the laser writer.

That is, according to aspects of the present disclosure, the movement of the printing head has a predetermined non-constant velocity profile, and the sweep deflection optic is controlled to carry out a micro-sweep based on a monitored position of the printing head along the scan direction. In this way, the micro-sweep can be initiated based on position rather than timing, thereby advantageously allowing the relative velocity of the printing head and the printing substrate to be decoupled from the control of the micro-sweeps. Put another way, the micro-sweeps are 'position triggered' such that, even if the printing head is accelerating, the printing pattern is correctly printed onto the printing substrate. Hence, printing can also be performed during acceleration of the printing head, thereby improving the printing efficiency.

The total incident energy on a unit area of the printing substrate may be referred to as the 'dose,' and may be controlled between 0 (or 0%, corresponding to no development of the unit area of the substrate) and 1 (or 100%, corresponding to a full development of the unit area of the substrate) according to the data pattern, or over 100% depending on the implementation. In some cases, the required dose as indicated in the data pattern may be some intermediate value, such as 50%.

The position triggering of the "start of sweep" (SoS) takes care of the dose reduction associated with a lower scan velocity. The sweep speed in the sweep direction is substantially unaffected by the changes in scan velocity as a result of the sweep direction being across the scan direction. Thus, each pixel along the sweep is exposed substantially in the same way regardless of the scan velocity. Accordingly, with position-triggered micro-sweeps, the same dose will be delivered to the printing substrate even with a lower scan velocity due to a lower frequency of the SoS.

In an optional refinement, the modulating optic is controlled to vary the intensity of each of the one or more laser beams further based on the predetermined non-constant velocity profile. In this way, if the one or more laser beams are directed at a particular unit area of the printing substrate (e.g., a pixel, which may be the smallest area unit used in the printing pattern) for a longer time as a result of a lower (average) velocity during an acceleration of the printing head relative to the printing substrate, the longer exposure time can be compensated for by controlling the modulating optic to reduce the relative intensity accordingly, such that the total incident energy is substantially the same as it would have been were the printing head and printing substrate moving with a constant velocity, as with conventional techniques.

The relative dose may be scaled (e.g., reduced) according to the predetermined non-constant velocity profile so as to achieve, e.g., an effective 50% dose when the one or more laser beams are incident on a unit area for a longer time, owing to a lower average velocity.

Put another way, the modulating optic may be configured to vary the intensity, based on the predetermined non-constant velocity profile, to thereby achieve a substantially uniform relative laser exposure per unit area of exposed printing substrate.

In some examples, the data pattern may be matched in time to the predetermined non-constant velocity profile, such that the variation of the control of the modulating optic, according to the predetermined non-constant velocity profile, is also predetermined. In some examples, the variation of the intensity of each of the one or more laser beams may be carried out dynamically according to a determined progression of the printing according to the predetermined non-constant velocity profile. For example, the state of the motion of the printing head, in terms of the non-constant velocity profile, may be monitored in terms of time or (relative) position.

Accordingly, the control of the modulating optic to vary the intensity of each of the one or more laser beams according to the predetermined non-constant velocity profile is advantageously synergistic with the 'triggering' of the micro-sweeps based on a monitored position, as an increased printing efficiency is achieved without impacting the printing accuracy, accuracy being of special importance when printing on micro- or nano-scales.

In preferred examples, the modulating optic is an acousto-optical modulator (AOM) and/or the sweep deflection optic is an acousto-optical deflector (AOD). AOMs and AODs may operate according to a similar principle, of acousto-optics, whereby a crystal material is subjected to acoustic waves at a particular amplitude and frequency, causing distortions in the material. The intensity of light passing through an acousto-optical component can be modulated by varying the amplitude of the acoustic waves. This is the primary function of the AOM. The deflection of light passing through an acousto-optical component can be varied by varying the frequency of the acoustic waves. This is the primary function of the AOD.

By increasing the frequency of the acoustic waves through the AOD over a time period, the deflection angle can be increased, thereby causing a 'sweep' (also called 'micro-sweep' herein) of the laser beam(s) across a portion of the printing substrate to be exposed in accordance with the data pattern, said pattern being encoded via modulation in the AOM.

In some alternative examples, the sweep deflection optic may comprise a rotating or resonating mirror, e.g., a polygonal mirror that is mechanically rotated, or a resonating microelectromechanical systems (MEMS) mirror.

The laser writer may be implemented with different form factors. For example, with a larger form factor, the laser writer may be configured to form photomasks for larger electronic displays. In such an example, the printing head may be mounted on a carriage, and the carriage may move the printing head in the scan direction, and between scans in the scan direction, a stage (on which the printing substrate is mounted) may slide relative to the carriage so as to cover the full area of the printing substrate during the printing operation. In another example, with a smaller form factor, the laser writer may be configured to form glass photomasks or printed silicon wafers for semiconductor electronics (although larger form factors may also be applied to printing on silicon wafers). In such an example, the printing head may move less during printing. The printing substrate may be moved relative to a static printing head and/or the printing head may be moved relative to a static printing substrate. That is, moving the printing head in the scan direction relative to the printing substrate may comprise moving the printing head along a static printing substrate, or moving the printing substrate along a static printing head.

The modulating optic and/or the sweep deflection option may be mounted in the printing head. Preferably, the modulating optic is mounted elsewhere on the laser writer, so as to reduce the weight of the printing head and reduce the complexity of the laser writer, e.g., by reducing mounting parts or moving parts. The sweep deflection optic is preferably mounted on the printing head. The printing head may comprise further optics, such as a 'final' lens, i.e., 'final' in the sense that it is the last optic before the one or more laser beams are incident upon the printing substrate or, put another way, the final lens is the final stage of the optical path. The sweep deflection optic may be the previous stage of the optical path before the final lens.

The micro-sweep control of the one or more laser beams may be entirely perpendicular to the scan direction, i.e., with 0-degree angle between the sweep control of the sweep deflection optic and the motion of the printing head. This angle may be referred to as the 'azimuth' angle of the one or more laser beams. However, conventionally, the one or more laser beams may have some non-zero azimuth angle. For example, the azimuth may be between 5 and 20 milliradians and fixed in conventional laser writers.

However, according to optional refinements of the presently disclosed aspects, the method for controlling the laser writer further comprises varying an azimuth angle of the laser beam from the sweep deflection optic to the printing substrate, wherein the varying of the azimuth angle varies the orientation of the sweep direction relative to the scan direction, and wherein the azimuth angle is varied based on the predetermined non-constant velocity profile. A non-zero azimuth angle may be used to compensate for scan velocity. A specific azimuth angle may be matched to a certain scan velocity to achieve perpendicular micro-sweeps on the substrate. If the velocity, is changed this may result in angled micro-sweeps on the substrate.

The micro-sweeps are preferably along substantially straight tracks, perpendicular to the scan direction. However, a non-constant velocity of the printing head relative to the printing substrate may risk the formation of curved or sloped tracks, which may thus reduce the accuracy of the printed pattern. Accordingly, by varying the azimuth angle of the micro-sweeps, and synergistically with the control of the modulating optic and the position-based triggering of the micro-sweeps, the accuracy of the printed pattern may be further increased, even when the printing occurs during a non-constant velocity of the printing head relative to the printing substrate.

The azimuth angle may be varied by mechanically rotating the sweep deflection optic before and/or during each micro-sweep of the laser beam and/or by an azimuth deflection optic arranged in the path of the one or more laser beams between the sweep deflection optic and the printing substrate.

Alternatively, the changes to the form of the micro-sweeps, owing to the non-constant velocity, may be pre-empted and compensated for in the data pattern. Thereafter, no further mechanical or optical compensation may be applied. That is, in some examples, the data pattern is pre-modified based on the predetermined non-constant velocity profile to compensate for azimuth variations expected to result from the non-constant motion of the printing head.

The sweep deflection optic may perform a plurality of micro-sweeps as the printing head moves relative to the printing substrate in the scan direction, where the plurality of micro-sweeps comprises at least a first micro-sweep at a first micro-sweep position along the scan direction, and a next micro-sweep at a next micro-sweep location further along the scan direction. Adjacent micro-sweeps may be spaced from each other, in the scan direction, by a height/width, such as a pixel height/width, which may be based at least in part on the effective area of the one or more laser beams as received on the printing substrate.

In some examples, the one or more laser beams may comprise an array of laser beams spaced from each other (preferably in a regular manner) in the scan direction. The laser beams in the array may be spaced from each other by more than a pixel height such that at least one of the micro-sweeps carried out by the array of laser beams overlap with the affected area of a previous micro-sweep, e.g., 'filling in' the unexposed portion(s) of the printing substrate between spaced apart exposed portions (corresponding to the spacing of the array of laser beams).

The sweep deflection optic may be configured to initiate the next micro-sweep upon determining, via the monitored position of the printing head, that the printing head is at the next micro-sweep position. The position of the printing head may be monitored using a position sensor, such as an interferometer and/or an encoder. Optionally, a sensed position obtained by the position sensor may have one or more compensations applied thereto to obtain the monitored position, where the one or more compensations are based on at least one predetermined position error.

The aspect(s) of the present disclosure described above are directed towards a method for controlling a laser writer, and may be realized as a series of computer-readable instructions for carrying out by a processor. Hence, the method may be a computer-implemented method. In an example, a computer program or a (transitory or non-transitory) computer-readable medium may be formed with instructions which, when the program is executed by a computer, cause the computer to carry out the method.

According to a further aspect of the present disclosure, there is provided a laser writer, comprising a printing head, a modulating optic, a sweep deflection optic, and a controller configured to control the modulating optic and the sweep deflection optic to thereby control one or more laser beams directed through the modulating optic and the sweep deflection optic. The controller is further configured to control the modulating optic, the sweep deflection optic and/or the printing head to carry out the method substantially as described above.

One or more advantages discussed above, or further advantages, brought about by the above-described method may transfer as advantages of a laser writer implementing such a method. Such further advantages may already be apparent from the above discussion, although they are not explicitly stated. Moreover, such further advantages, or others, may be realized through appreciating specific implementations of aspects of the present disclosure, one or more of which are described below.

### Brief Description of the Drawings

One or more embodiments will be described, by way of example only, and with reference to the following figures, in which:
Figure 1A schematically shows an example laser writer, viewed side on, perpendicular to a scan direction;
Figure 1B schematically shows the laser writer from above, part-way through a printing operation;
Figure 1C shows a portion of the printing pattern being printed onto the printing substrate by the laser writer as shown in figures 1A and 1B;
Figure 1D shows a representation of portions of pattern data generated from the printing pattern shown in figure 1C;
Figure 1E schematically shows the laser writer, viewed side on, along the scan direction, with representations of data input into the illustrated optics for an example portion of pattern data;
Figure 2 illustrates an example non-constant velocity profile for a laser writer;
Figure 3 illustrates a method for controlling a laser writer; and
Figure 4 schematically shows a position triggering scheme.

### Detailed Description

The present disclosure is described in the following by way of a number of illustrative examples. It will be appreciated that these examples are provided for illustration and explanation only and are not intended to be limiting on the scope of the disclosure.

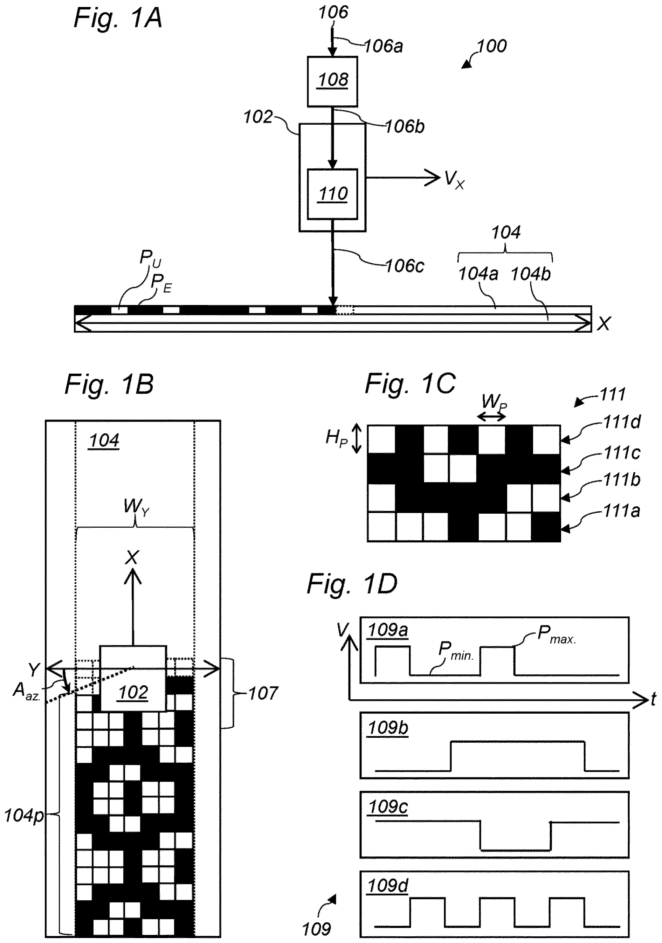

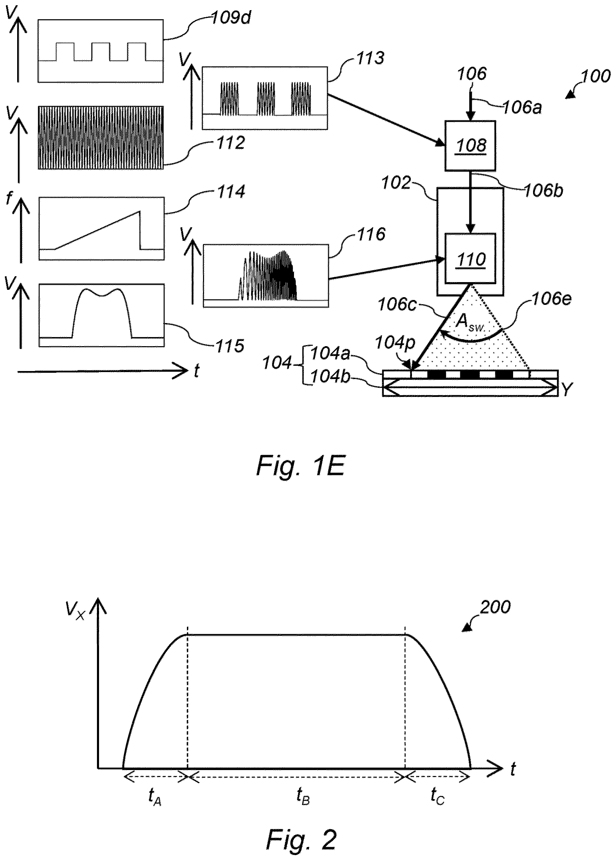

Figure 1 schematically shows an example laser writer 100 comprising a printing head 102 moving in a scan direction *X* relative to a printing substrate 104. In this example, the printing substrate 104 comprises a photoresist layer 104a on top of a base layer 104b. Herein, the printing substrate 104 may also be referred to as simply `substrate 104'.

The laser writer 100 is shown during a printing operation, wherein a laser beam 106 (also referred to herein as simply 'beam 106') is directed to a modulating optic 108. In this example, the modulating optic 108 is an acousto-optic modulator, and thus the modulating optic 108 may also be referred to as 'AOM 108'.

The beam 106 may originate from a laser source (not shown) and may pass through one or more components between the laser source and the AOM 108. Furthermore, although the AOM 108 is shown as being outside the printing head 102, and above the printing head 102, it will be appreciated that this is purely schematic and the AOM 108 may be installed elsewhere on the laser writer 100. For the sake of the present discussion, the portion 106a of the beam 106 entering the AOM 108 shall be considered as being substantially unmodified.

As discussed in more detail below, the AOM 108 is controlled according to a data pattern to modulate the intensity of the beam 106, where the data pattern corresponds to a printing pattern to be printed onto the printing substrate 104. In figure 1A, the pattern can be seen being printed onto the substrate 104, where the pattern is formed of a number of pixels, including unexposed pixels *P_{U}* and exposed pixels *P_{E}.* It will be appreciated that, in other examples, partially exposed pixels may form part of the pattern.

The laser writer 100 further comprises a sweep deflection optic 110. In this example, the sweep deflection optic 110 is an acousto-optic deflector, and thus the sweep deflection optic 110 may also be referred to as 'AOD 110'.

The portion 106b of the beam 106 has been modulated according to a data pattern, and is directed from the AOM 108 to the AOD 110. The AOD 110 is controlled according to a sweep pattern (discussed in more detail below) to vary a deflection angle of the beam 106 over time to thereby achieve a micro-sweep of the laser beam across the printing substrate in a sweep direction *Y* substantially perpendicular to the scan direction *X*.

The AOD 110 is comprised in the printing head 102. The printing head 102 is moved with a velocity *V_{X}* along the substrate 104 during printing. In this example, the printing head 102 is scanned along a static substrate 104. In other examples, the substrate 104 may be moved in addition or as an alternative to the motion of the printing head 102.

In figure 1A, the portion 106c of the beam 106 represents the deflected beam 106 performing the micro-sweep, although, from this side on view, the sweep direction cannot be seen. The portion 106c of the beam between the AOD 110 and the substrate 104 is shown angled directly downwards. In alternative configurations, the beam 106c may be angled differently.

Figure 1B shows a top view of the laser writer 100, which more clearly shows the printed substrate 104p, having a printed pattern. In this example, the printing head 102 scans along the substrate 104 in the scanning direction *X* and, using the AOD 110, carries out a plurality of micro-sweeps in the sweep direction *Y,* substantially perpendicular to the scanning direction *X*. In this way, a sweep width *W_{Y}* of the substrate 104 can be exposed for each scan of the printing head 102 along the substrate 104 in the scanning direction *X*.

It will be appreciated that, with a sweeping speed substantially greater than the scanning speed (i.e., *V_{X}*)*,* an overall printing efficiency of the laser writer 100 can be greatly enhanced by using micro-sweeps.

The sweep direction Y is shown as a solid arrow, and an example orientation of the AOD 110 relative to the sweep direction *Y* is illustrated in a dotted line, which has a non-zero azimuth angle *A*_{*az*.}. It will be appreciated that the sweep direction resulting from the non-zero azimuth angle *A*_{*az*.} may be substantially perpendicular to the scan direction *X*, i.e., substantially aligned with the illustrated sweep direction *Y.*

Normally, when writing at constant velocity *V_{X}*, the relative motion between the printing head 102 and the substrate 104 may involve the AOD 110 being arranged at a fixed azimuth angle *A*_{*az*.} in order for the micro-sweep to result in printing in a straight line, e.g., substantially perpendicular to the scan direction *X*. For constant velocity *V_{X}*, the azimuth angle *A*_{*az*.} is also constant throughout printing. However, with a non-constant velocity *V_{X}*, the azimuth angle *A*_{*az*.} may be dynamically adjusted based on the velocity *V_{X}* of the printing head 102. Alternatively, the pattern data (discussed more below) sent to the AOM 108 may be compensated in pre-processing based on the predetermined velocity profile *V_{X}*. It will be appreciated that the 'sweep direction' may be the direction the path of the one or more laser beams takes, which may be a different direction to the relative orientation of the AOD 110, for reasons made clear from the above discussion.

Figure 1C shows four rows 111a, 111b, 111c, 111d of a printing pattern 111 to be printed onto the substrate. In figure 1B, the printing head is shown mid-sweep carrying out the printing of row 111c. The printing pattern 111 is shown made up of a plurality of pixels, having a height *H_{P}* and a width *W_{P}.* In this example, the pixels are square such that the height *H_{P}* and the width *W_{P}* is the same. It will be understood that the size of the pixels may be configured to correspond to a width of the beam 106, or vice versa.

In this example, each of the rows 111a, 111b, 111c, 111d is printed by a respective micro-sweep of the beam 106 along the sweep direction Y. In this example, the total sweep length *W_{Y}* comprises seven pixel widths *W_{P}.* Hence, as discussed below, each micro-sweep may comprise (at least) seven different modulation intensities for the beam 106. In the illustrated example, the printing pattern 111 is entirely aligned to the pixel grid, and thus only requires an incident energy (or 'dose') of 0% laser intensity (white) or 100% laser intensity (black) to form. In other examples, the printing pattern 111 may be misaligned with the pixel grid for the laser writer 100, in which case some intermediate dose for a pixel may be used.

Example parts 109a, 109b, 109c, 109d of a data pattern 109 generated from the printing pattern are shown in figure 1D. Part 109a corresponds to row 111a, part 109b corresponds to row 111b, part 109c corresponds to row 111c, and part 109d corresponds to row 111d. Each part 109a, 109b, 109c, 109d may be provided in sequence to the control of the AOM 108 (as discussed in more detail below), such that the beam 106 is modulated during each micro-sweep, corresponding to a respective row 111a, 111b, 111c, 111d of the printing pattern 109, to thereby print the printing pattern 109 onto the substrate.

As shown in figure 1D, the data pattern 109 may be a time-varying voltage signal, and may be constrained between a minimum, corresponding to a minimum laser intensity *Pₘᵢₙ.* and a maximum, corresponding to a maximum laser intensity *P_{max.}*. It can be seen that, by varying the intensity of the beam 106 according to, e.g., the part 109d of the data pattern 109 during a particular micro-sweep, the row 111d of the printing pattern 111d may be printed onto the substrate 104. This example is illustrated in more detail in figure 1E.

Figure 1E schematically shows the laser writer 100 in a side on view, along the scanning direction *X*. Parts of the laser writer 100 that have already been discussed in connection with the previous figures may not be discussed again in detail.

As shown in figure 1E, a part 109d of a data pattern 109 is combined with a carrier signal 112, which may be a relatively high frequency signal, to generate an AOM driving signal 113 to be provided to the AOM 108 or, more specifically, to an acoustic driver thereof (not shown in detail). The acoustic driver may then vibrate according to the AOM driving signal 113 and may modulate (i.e., amplitude modulation over time) the intensity of the beam 106 accordingly to thereby form a modulated beam 106b.

The modulated beam 106b, having the part 109d of the data pattern 109 encoded therein, said part 109d of the data pattern 109 being generated from the row 111d of the printing pattern 111, is then provided to the AOD 110 in the printing head 102.

The AOD 110 also comprises an acoustic driver (not shown in detail). The AOD 110 (or more specifically the acoustic driver thereof) is controlled according to a sweep pattern 114 to vary a deflection angle *A*_{*sw*.} of the modulated beam 106b beam over time *t* to thereby achieve a micro-sweep of the beam 106 across the substrate 104 in the sweep direction *Y.*

The sweep pattern 114, shown as a changing frequency *f* over time *t*, may cause the acoustic driver to deflect the beam 106 with a deflection angle *A*_{*sw*.} that increases over time, thereby forming the micro-sweep. In some cases, the micro-sweep may start from a deflection to a first direction, passed through an undeflected position, and then progress to a deflection in a second direction, wherein the first and second directions are opposite each other in the axis of the sweep direction. In other cases, the micro-sweep may begin with no deflection and may progress to an increasing deflection in a single direction. It will be appreciated that the path 106e of the beam 106c (the full swept extent of which is shown shaded) in figure 1E may be configured through configuring the sweep pattern 114.

Moreover, the incident energy of the sweeping beam 106c may vary as the beam 106 is swept across the substrate 104 during the micro-sweep. This may be a result of varying distances between the AOD 110 and the substrate, varying attenuation of the AOD 110 depending on deflection angle, or some other reason.

To compensate for such variations, the sweep pattern 114 may be combined with an AOD power modulation 115, such that an AOD driver signal 116 is created for providing to the acoustic driver of the AOD 110. The sweep pattern 114 may comprise a frequency modulation, and the AOD power modulation 115 may comprise an amplitude modulation.

Figure 2 shows an example non-constant velocity profile 200 (also referred to as simply 'profile 200') for the motion of the printing head of a laser writer, such as the printing head 102 shown in previous figures. The profile 200 corresponds to the velocity *V_{X}* of the printing head over time *t.*

In this example, the profile 200 comprises three main time periods *t_{A}*, *t_{B}*, and tc. In the first time period *t_{A}*, the printing head is accelerating from rest to a maximum velocity. In the second time period *t_{B}*, the printing head is at a constant velocity, which in this example is a maximum velocity in the velocity profile 200. In the third time period tc, the printing head decelerates from the constant (maximum) velocity back to rest.

The profile 200 shown in figure 2 may represent a scan of the printing head along a substrate, along the scanning direction. A printing operation may comprise a plurality of scans along the substrate, where the printing head moves along the substrate between each scan, thereby covering the entire printable part of the printing substrate.

The profile 200 may be predetermined in that this scanning motion of the printing head may be controlled by a motion controller having preconfigured instructions. Additionally or alternatively, the scanning motion may be recorded or measured to thereby predetermine how the printing head will move during subsequent scanning motions. The profile 200 may be stored in any suitable way for carrying out the intensity compensations as discussed above, and may be referred to in any suitable way, e.g., as a look-up table or the like, based on monitored position of the printing head, based on a time progress through the scanning motion, etc.

During the first time period *t_{A}*, the laser writer may be travelling at an increasing below-maximum velocity. As a result, the sweeps may be triggered less often during this period, assuming that the position triggers are evenly spaced with respect to the printing pattern, such as every pixel width or a multiple thereof.

In some examples, for example when the changes in velocity are quite large in the non-constant velocity profile, an AOM may compensate for a lower velocity in the scan direction during each sweep. Therefore, the relative dose during writing, e.g., per pixel, may be reduced to compensate for the increased amount of time that the laser is incident upon each pixel. Moreover, the azimuth angle may also be adjusted to correspond to the changing velocity. Throughout the first time period *t_{A}*, the relative dose and/or azimuth angle may be reduced less and less until the printing head reaches the maximum velocity at the start of the second time period *t_{B}*.

During the second time period *t_{B}*, the laser writer may be travelling at a maximum and constant velocity. Therefore, the frequency of sweeps, the relative dose during writing, e.g., per pixel, and/or the azimuth angle may remain constant until the printing head begins to decelerate towards the end of the scan, at the start of the third time period *t_{C}.*

During the third time period *t_{C},* the laser writer may be travelling at a decreasing below-maximum velocity. As a result, the sweeps may again be triggered less often during this period.

The relative dose during writing, e.g., per pixel, and the azimuth angle may again be reduced to compensate for the increased amount of time that the laser is incident upon each pixel. Throughout the third time period tc, the relative dose and/or azimuth angle may be reduced more and more until the printing head reaches a minimum velocity, at which point the printing head may cease writing.

In some examples, a threshold velocity may be defined, below which the laser writer does not write. Hence, a portion at the start of the first time period *t_{A}* and a portion at the end of the third time period *t_{C}* may comprise time periods where the laser does not write.

It will be appreciated from figure 2 that the first time period *t_{A}* and the third time period *t*_{C} constitute a substantial portion of the overall scan period (e.g., about 30%). Hence, it is seen that the laser writer, being enabled to continue writing even during these times of changing velocity, can perform substantially more printing per scan, thereby increasing the printing efficiency greatly. In this way, the printing throughput of the laser writer can also be increased.

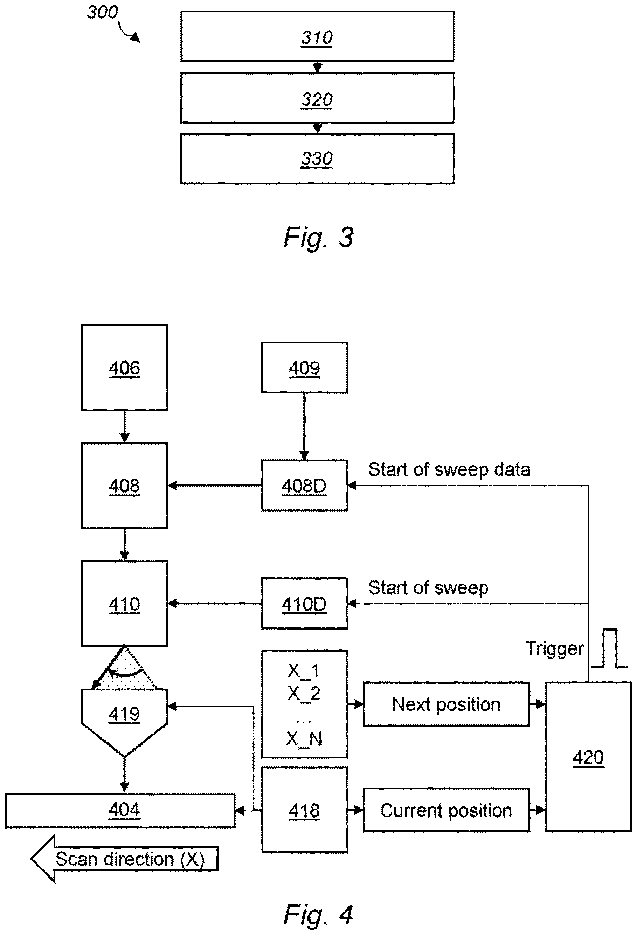

Figure 3 illustrates a method 300 for controlling a laser writer, such as the laser writer 100 shown in the previous figures.

The method 300 comprises moving 310 a printing head in a scan direction relative to a printing substrate, directing 320 one or more laser beams through a modulating optic, and directing 330 the one or more laser beams from the modulating optic to a sweep deflection optic. After deflection by the sweep deflection optic, the one or more laser beams may be incident upon a printing substrate, as discussed above.

According to the method 300, the movement of the printing head has a predetermined non-constant velocity profile, and the modulating optic is controlled according to a data pattern to modulate the intensity of each of the one or more laser beams, wherein the data pattern corresponds to a printing pattern to be printed onto the printing substrate.

According to the method 300, the sweep deflection optic is controlled according to a sweep pattern to vary a deflection angle of the one or more laser beams over time to thereby achieve a micro-sweep of the laser beam across the printing substrate in a sweep direction substantially perpendicular to the scan direction, and the sweep deflection optic is controlled to carry out a micro-sweep further based on a monitored position of the printing head along the scan direction. Put another way, the sweeps are position-triggered, where an example of a position triggering scheme is discussed below in connection to figure 4.

The method 300 may be stored as instructions in a memory and may be carried out by a controller. The controller may further be configured to control the modulating optic, the sweep deflection optic and/or the printing head (e.g., the motion thereof) to thereby cause the laser writer to carry out the method 300. In some examples, a laser writer may be retrofitted with the capabilities of the method, to thereby increase its printing efficiency.

Figure 4 schematically shows an example position triggering arrangement. As discussed before, a laser 406 is directed through an AOM 408 and to an AOD 410, which sweeps the laser across a final lens 419 before being incident upon a printing substrate 404, thereby printing onto the printing substrate 404.

An AOM driver 408D is controlled to vary the intensity of the laser beam(s) according to pattern data 409. The pattern data 409 may be portioned into a plurality of portions corresponding to each sweep. For example, with reference to figure 1C, each row 111a-d may be a respective portion of pattern data corresponding to each sweep.

An AOD driver 410D drives the AOD in a manner similar to that discussed in relation to figure 1E. The AOD driver 410D thus controls when and how the sweeps are performed by the AOD.

In this example, to enact position triggering of sweeps, the arrangement further comprises a position sensor 418, configured to sense the position of the printing head (e.g., the final lens 419 thereof) relative to the printing substrate 404. The position sensor may comprise an interferometer and an encoder. The position sensor 418 provides information of the current position to a comparator 420.

Also provided to the comparator is a list of trigger positions X_1, X_2, ..., X_N, which may be predetermined and stored in a data storage. The trigger positions may be associated with the pattern data 409, synchronized with the pattern data 409, or may be part of a separate data stream. The trigger positions may correspond to a distance along the scan direction X for a particular scan along the printing substrate 404, and thus the trigger positions may be one-dimensional (i.e., only in the X-direction). In other examples, the trigger positions may be two-dimensional.

When the comparator 420 determines that the current position corresponds to a trigger position (e.g., X_1), a trigger signal is generated and provided to the AOM driver 408D and/or the AOD driver 410D. The trigger signal causes a start of sweep (SoS) by the AOD driver 410D and the sweep data is encoded into the laser during said sweep by the AOM driver 408D.

In this way, the SoS is triggered based on the position of the printing head relative to the printing substrate 404. Therefore, the non-constant velocity profile of the printing head relative to the printing substrate 404 can be advantageously accounted for, and printing can be performed even during periods of acceleration. Hence, the printing efficiency can be greatly enhanced.

While the present disclosure is susceptible to various modifications and alternative forms, specific embodiments are shown and described by way of example in relation to the drawings, with a view to clearly explaining the various advantageous aspects of the present disclosure. It should be understood, however, that the detailed description herein and the drawings attached hereto are not intended to limit the disclosure to the particular form disclosed. Rather, the intention is to cover all modifications, equivalents, and alternatives falling within the scope of the following claims.

## Claims

1. A method for controlling a laser writer, comprising:
moving a printing head in a scan direction relative to a printing substrate,
wherein the movement of the printing head has a predetermined non-constant velocity profile;
directing one or more laser beams through a modulating optic,
wherein the modulating optic is controlled according to a data pattern to modulate the intensity of each of the one or more laser beams, and
wherein the data pattern corresponds to a printing pattern to be printed onto the printing substrate;
directing the one or more laser beams from the modulating optic to a sweep deflection optic;
wherein the sweep deflection optic is controlled according to a sweep pattern to vary a deflection angle of the one or more laser beams over time to thereby achieve a micro-sweep of the laser beam across the printing substrate in a sweep direction substantially perpendicular to the scan direction; and
wherein the sweep deflection optic is controlled to carry out a micro-sweep further based on a monitored position of the printing head along the scan direction.

2. The method according to claim 1, wherein the modulating optic is controlled to vary the intensity of each of the one or more laser beams further based on the predetermined non-constant velocity profile.

3. The method according to claim 1 or claim 2, wherein the modulating optic is an acousto-optical modulator (AOM).

4. The method according to any preceding claim, wherein the sweep deflection optic is an acousto-optical deflector (AOD).

5. The method according to any preceding claim, wherein the modulating optic and/or the sweep deflection option are mounted in the printing head.

6. The method according to any preceding claim, further comprising varying an azimuth angle of the laser beam from the sweep deflection optic to the printing substrate, wherein the varying of the azimuth angle varies the orientation of the sweep direction relative to the scan direction, and wherein the azimuth angle is varied based on the predetermined non-constant velocity profile.

7. The method according to claim 6, wherein the azimuth angle is varied by mechanically rotating the sweep deflection optic before and/or during each micro-sweep of the laser beam.

8. The method according to claim 6 or claim 7, wherein the azimuth angle is varied by an azimuth deflection optic arranged in the path of the one or more laser beams between the sweep deflection optic and the printing substrate.

9. The method according to any of claims 1 to 5, wherein the data pattern is pre-modified based on the predetermined non-constant velocity profile to compensate for azimuth variations expected to result from the non-constant motion of the printing head.

10. The method according to any preceding claim, wherein moving the printing head in the scan direction relative to the printing substrate comprises moving the printing head along a static printing substrate, or moving the printing substrate along a static printing head.

11. The method according to any preceding claim, wherein the modulating optic is configured to vary the intensity, based on the predetermined non-constant velocity profile, to thereby achieve a substantially uniform relative laser exposure per unit area of exposed printing substrate.

12. The method according to any preceding claim, wherein the sweep deflection optic performs a plurality of micro-sweeps as the printing head moves relative to the printing substrate in the scan direction, the plurality of micro-sweeps comprising at least a first micro-sweep at a first micro-sweep position along the scan direction, and a next micro-sweep at a next micro-sweep location further along the scan direction.

13. The method according to claim 12, wherein the sweep deflection optic is configured to initiate the next micro-sweep upon determining, via the monitored position of the printing head, that the printing head is at the next micro-sweep position.

14. The method according to any preceding claim, wherein the position of the printing head is monitored using a position sensor, and wherein the position sensor comprises an interferometer and/or an encoder.

15. The method according to claim 14, wherein a sensed position obtained by the position sensor has one or more compensations applied thereto to obtain the monitored position, the one or more compensations being based on at least one predetermined position error.

16. A laser writer comprising:
a printing head;
a modulating optic;
a sweep deflection optic; and
a controller configured to control the modulating optic and the sweep deflection optic to thereby control one or more laser beams directed through the modulating optic and the sweep deflection optic,
wherein the controller is configured to control the modulating optic, the sweep deflection optic and/or the printing head to carry out the method according to any preceding claim.
